# EUROPEAN PATENT SPECIFICATION

(11) **EP 2 307 852 B1**
(45) Date of publication and mention of the grant of the patent: **09.05.2012**
(21) Application number: 10721199.7
(22) Date of filing: 02.03.2010
(51) Int. Cl.: G01B 11/06, G01B 11/25

(54) **METHOD AND DEVICE FOR OPTICALLY MEASURING THE SURFACE OF A PRODUCT**
VERFAHREN UND VORRICHTUNG ZUR OPTISCHEN MESSUNG DER OBERFLÄCHE EINES PRODUKTS
PROCÉDÉ ET DISPOSITIF DE MESURE OPTIQUE DE LA SURFACE D'UN PRODUIT

(30) Priority: 03.03.2009 CZ 20090133; 27.08.2009 EP 09466016
(43) Date of publication of application: 13.04.2011
(73) Proprietor: WiTrins s.r.o., 25064 Hovorcovice (CZ)
(72) Inventor: WIESER, Roman Franz, 250 64 Hovorcovice (CZ)
(74) Representative: advotec.
(86) International application number: PCT/IB2010/000944
(87) International publication number: WO 2010/100571

(56) References cited:
- WO-A1-02/082009
- JP-A- 61 075 210
- JP-B- 7 117 399

## Description

### Field of the Invention

The present invention in general relates to a device and a method for measuring and inspecting a distance between a sensor and a product under testing. In particular, it can be used in the field of electronics for the measurement and testing of the position of the components mounted on printed circuit boards (PCBs) or on a solar cell product or for inspecting the position of connectors of electronic components, such as ICs, capacitors, transistors, resistors etc., or the position of reflow soldering paste prior to mounting electronic components on a PCB for reflow soldering. The present invention is preferably applicable to the production of PCBs, solar cell products such as solar cell wafers or solar cell elements and other items that require a measurement of flatness in order to thusly specify their quality and can also be used for testing the surface roughness of product surfaces. The present invention can also be used for inspecting a three-dimensional form of various items when recording an image without the necessity of performing scanning operations from several positions, which is particularly advantageous in high-production processes, i.e. in processes where testing of the surface roughness and defects etc. is required.

### Background of the Intention

From the state of the art such surface height measurements are most frequently performed with the aid of a line laser and a high-speed camera, preferably using a laser triangulation technique. The line laser is directed to the measured surface and the camera, which is directed below the specified angle, records the profile of the measured area in one coordinate (in one place) so that the laser lights it up. The individual images are recorded with the frequency corresponding to the width of the laser beam and all images are then composed. Using this procedure, it is possible to compose a 3D model.
Another method is the use of several cameras which are directed to the tested area from various angles. From the known trigonometry of the camera inside the tester, a 3D model can be composed.
A further method is the use of the Moire effect by means of which, under certain circumstances, it is possible to make the relief of the tested area visible. Images are produced through two line grids, always with inverse brightness. After composition of both images, when using the interference effect, the relief of the surface is reflected.

Document WO 02/082009 A1 teaches a method and an apparatus for measuring a distance between a sensor and a product using colour information of light reflected by the object. The colour distribution of the three-dimensional surface correlates with a height level of the object's surface so that colour information can be used for analyzing the three-dimensional structure of the object's surface. The white light source can be a tungsten lamb or a combination of multiple multicoloured light sources with a plurality of light beams with single wavelengths.

From JP 61 075210 A one can learn about a range finder apparatus wherein light of a light source is diffracted into a multicoloured beam illuminating a surface of an object. The ratio of signal intensity of light reflected by the object's surface which is filtered by two different filters can be used for measuring angles and distances between the object's surface and the camera.

Finally JP 7 117399 B discloses another range sensing apparatus defining a general state of the art.

The methods known from the state of the art do not allow for obtaining surface height information with a precision of less than +/- 20µm. Furthermore, a maximal scanning width of a measured product is limited, making it infeasible to scan products being wider than 150 mm. The scanning speed is limited thus making surface measurement to a bottle neck of a high speed production process.

It is consequently an object of the present invention to provide a method and a device for measuring and inspecting a surface of a product with high precision, high speed, variable measurement resolution and with an increased *y* width. Furthermore, it is an object of the present invention to provide a method and a device being capable of performing a self-calibration, thus eliminating high-precision structural construction and complicated calibration efforts.

The above-mentioned problems of the state of the art are solved by a device and a method according to the independent claims. Advantageous embodiments are the subject-matter of the dependent claims.

### Summary of the Invention

The present invention provides a device according to claim 1 and a method according to claim 9.

The present invention provides a device for optically measuring the surface of a tested product, which enables performing an inspection of the surface of a product, a component alignment inspection or an inspection of soldering paste arrangement prior to a reflow soldering process, and which enables a creation of an optical 3D model of the product surface. The device comprises the following components:
- a white light source, advantageously emitting a white light beam with a continuous spectrum. The light is rectified by a collimation unit including optical means, such as lenses, aperture means etc., into a parallel, narrow and collimated beam which then passes through a spectrometer unit, preferably an optical prism or an diffraction grading. Preferably, the aperture means comprises a slit diaphragm for producing a flat and broad expanded beam of white light.
- a spectrometer unit, especially an optical prism, mediating a decomposition of the white light into a multichromatic light beam comprising a broad frequency spectrum of light. The multichromatic light entering the prism contains selected or all colour components of the white light. After passing through the spectrometer unit, the white light disintegrates into individual colours according to the law of light refraction. The individual components are monochromatic having different hue values, whereby the multichromatic beam comprises a spectrum being spatially distributed and illuminating a surface of a product under testing in a scanning direction. The width of this spectrum directly influences the measuring precision of a z-axis height of the product surface.
- a camera, preferably a line scanning camera. The camera gradually records the tested surface line by line while the product under testing is moved relative to the camera in a x-axis scanning direction. The geometric position of the camera and the light source, while recording the whole time, remains the same. The camera and the light are adjusted to zero height line by line (ground) so that the camera displays the beginning of the spectrum, i.e. the red colour. All non-zero heights are then displayed in another colour as they are in the colour spectrum. Thereby it should be pointed out that either the product under test is moved relative to white light source, spectrometer unit and camera, or white light source, spectrometer unit and camera are relatively moved with respect to the product under test.

In other words, the device for optically measuring the surface of a tested product, especially for inspecting a PCB-product for reflow soldering paste inspection, comprises at least one white light source for emitting a beam of white light, at least one collimation unit for collimating said beam of white light, at least one spectrometer unit, preferably an optical prism or an optical diffraction grading for splitting said beam of white light into a beam of multichromatic light being directed onto said tested product under a predetermined incident angle γ, and at least one camera for recording a reflected beam of monochromatic light of said tested product. In this way, a z-axis surface height information of said tested product can be extracted from a hue value of said reflected beam of monochromatic light while relatively moving said tested product in a x-axis scanning direction.

The collimation unit can preferably collimate the light at least to a collimation quality of 2° or less in all directions. In contrast to parallel light, collimated light creates highly-parallelized light beams of all colours/hue values. The collimation unit can comprise optical rectifying means, such as lenses, apertures or mirrors, to collimate the light in 360°. From the collimated light a multichromatic spectral line of light is formed by the spectrometer unit, wherein the individual colours/hue values are represented in such a manner so as to be distinguishable from one another. For directing said light, a light mixing means, e.g. an aperture or a fibre, can be used.

According to an advantageous embodiment, said white light source can have a continuous spectrum. Alternatively or additionally, the frequency-bandwidth of the spectrum can be variable, preferably in a wavelength range of 350-850 nm (ultraviolet to infrared). Alternatively or additionally, the intensity of the white light source can be adjustable, preferably by dimming of said light source or by selectively switching two or more light sources on or off in parallel.

According to another favourable embodiment of the invention, an ensemble of a white light source, a collimation unit and a spectrometer unit can be represented by an LCD-projector, a video projector or another video imaging device being capable of producing a beam of multicoloured light. As such a projector usually comprises a white light beam, a collimation unit for rectifying and collimating said beam of white light and a spectrometer unit, for instance an multicolour-LCD for converting said beam of white light to a beam of multicoloured light. Usually specifications of a multichromatic beam of light, such as brightness, opening angle, width of different parts of said coloured beam etc, produced by an LCD-projector can easily be controlled by an image control unit for producing a multichromatic beam of light with different colour-width resolution such that a measurement accuracy can easily be controlled. Furtheremore such LCD-projector is capable of producing 100 fps (frames per second) or even more for adaptively changing the shape of the beam. A projector can easily be combined with an area- or a line scanning camera for providing an embodiment of the invention.

According to another advantageous embodiment, said white light source can be adapted for producing a white light stripbeam. Alternatively or additionally, said light source can be a LED light source, preferably a LED stripe, wherein at least one microlens can be optically coupled to at least one LED for pre-rectification of said beam of white light. Alternatively or additionally, multiple LEDs of a LED stripe can be selectively switched either on or off for enhancing intensity and/or length of a white light beam in a y-axis direction perpendicular to said scanning direction. Alternatively or additionally, a LED stripe can comprise multiple differently coloured LEDs for mixing multi-coloured light to a white light beam for providing an adjustable frequency spectrum of said white light beam. Preferably, said LED stripe comprises one or more LEDs. LEDs produce a non-collimated light which radiates in all directions, thus the radiation of the light has to be pre-rectified according to the structure of the LED stripe.

Said light stripe can be adapted to a desired scanning width such that the device can inspect products with different y-axis widths. Favourably the light stripe can have a width of a maximal scanning width, whereby said "long" beam of white light can be adaptively focused to a "short" beam of white light by a parallax free optic. For instance such a light stripe can have a length of 450-600mm in y-axis direction and the length of said flat beam of white light can be focused by a parallax free optic to a length of 150mm. The z height resolution can be adapted by a variable aperture width, spectrometric angle of said spectrometer unit or distance of spectrometer unit from the surface. Due to the variability of z height resolution, different scanning resolutions can be achieved. The y-width of the light stripe can be enlarged by using mirrors, light guiding elements, such as fibres, or lenses etc.

A light stripe can also be produced from a punctual light source by use of an objective and/or a cylinder lens. Thereby, the choice of different glasses can adjust different refraction indices and can enhance a parallax-free image.

LEDs often produce inhomogeneously distributed white light. Therefore, it can be advantageous to mix different kinds of white or multi-coloured LEDs for producing a homogeneous white light spectrum. Such a mixture can be achieved by using lenses, mirrors, glass fibre optics or the like. Furthermore, several light stripes can be used in parallel for the addition of light beams in order to enhance scanning velocity.

The quality of the white light can be further enhanced by integrating a polarising filter element into the white light source for reducing reflection effects and is especially advantageous for illuminating metallic/non-metallic surfaces.
In conclusion, the quality of the white light can be enhanced by:
- variable aperture size;
- spectral homogeneity of the white light beam;
- parallax-free light for reducing shadowing effects;
- optical means for adapting light stripe length to aperture length in y-direction;
- light intensity control means for adjusting surface reflection effects;
- adaptable light stripe length for adapting scanning width to product dimensions:

According to another advantageous embodiment said collimation unit can be adapted to collimate said white light beam in 360° and can be adapted to form a white light stripbeam being perpendicular to said scanning direction and can preferably comprise at least one lens and/or a collimation grid and/or at least one aperture means, preferably an adjustable slit diaphragm aperture means.

According to another advantageous embodiment, said device can also comprise a scanning transportation means for relatively transporting said tested product or said light source, spectrometer unit, collimation unit and camera in a scanning direction.

According to another advantageous embodiment said camera can be a line scanning camera, preferably comprising a camera aperture unit and/or a parallax lens unit for reducing parallax effects, especially a cylinder lens or a round lens unit, for receiving a beam of monochromatic light reflected from said beam of multichromatic light by said tested product. Alternatively or additionally, said camera can be a digital camera with at least 8 Bit hue resolution, preferably an adjustable 10, 12 Bit or higher hue resolution. Alternatively or additionally, said camera can comprise two or more line scanning rows, each row comprising a colour filter for increasing hue sensitivity. Alternatively or additionally, said camera can comprise at least one grey or black/white scanning row for enhancing scanning quality. Alternatively, said camera can be an area scanning camera, whereby single or multiple scanning rows of said scanning area can be extracted for hue height information processing. Such an area camera can preferably have 1500 rows or more and can be used for resolutions down to 20µm. Advantageously the camera comprises two or more scanning lines with different colour filter elements in front of said two or more scanning lines enhancing sensitivity of each scanning line to different hue values by said different colour filter elements.

Due to a large y scanning width of a camera perpendicular to a x-axis scanning movement direction, a scanned image can comprise parallax-related errors. Using parallax lenses in a line of sight between product surface and camera but also between white light source and spectrometer unit, allows for correcting parallax errors, thus enabling a 3D scan of a product without high quality. A parallax lens system is supposed to correct different light diffraction characteristics of all wavelengths. The lens system can comprise length-extended cylinder lenses but also round lenses. Cylinder lenses can be advantageous when using a line scanning camera.

The degree of z height resolution is a result of a combination of reflected hue values of the spectral light and colour resolution accuracy of said camera. CCDs or other digital cameras usually can provide 8-10 Bit colour resolution per pixel. Adjusting colour resolution of the camera can increase measurement resolution. Use of different numbers of camera lines for scanning can be another possibility of scaling measurement resolution. For instance a two line camera can be used and the camera can focus on two or more different colour areas such that a scalable resolution can be achieved. The number of camera lines can also be increased to four or even more scanning lines, whereby different colour filters can be assigned to individual camera line rows, thus enhancing resolution accuracy.

Use of an area camera or multiple line cameras being capable of scanning a surface area of the tested product instead of a line camera scanning a y-axis surface line perpendicular to a x-axis scanning movement direction can also be advantageously used as a scanning camera. Individual lines of the image produced by the surface area can be extracted as multiple scanning rows, whereby an increasing number of extracted rows can increase the measurement accuracy. Furthermore, a scanning speed can be increased by extracting multiple scanning rows at once.

A camera can comprise one or more colour-sensitive scanning rows and at least one black/white or grey scanning row. As such, the black/white or grey scanning row can scan a 2D image of the product surface for providing x/y dimensions of the product. The colour scanning row provides hue information of the z height of the product surface such that in one scanning process x/y and z dimension values of the product can be extracted. Especially if a surface of a product is full of fissures, a 2D image provides exact x/y dimensions for associating z data to distinct surface areas of the product.

It can be advantageous to use a camera comprising a processing unit for directly converting hue values to z height values based on calibration data of a hue height map. Thus, the camera's processing unit can directly convert camera RAW data into z height data which can be transmitted to a control unit. Furthermore, said processing unit can use different calibration routines, such as extraction of brightness, conversion of RGB in HSI data (Hue, Saturation, Intensity), geometric calibration based on row data capturing and row shift calculation etc.. Thus, the camera is capable of directly outputting z height measurement data, whereby the camera can provide 3D area data of the scanned product.

According to another advantageous embodiment at least two or more cameras can be arranged in a y-axis direction perpendicular to said x scanning direction for parallel scanning, thus enhancing scanning width of said product. Alternatively or additionally, said two or more cameras can be stereometrically arranged for 3D scanning of said product for reducing shadowing and illumination effects. Arranging two or even more cameras in one scanning row perpendicular to a scanning direction can increase scanning width, thus enabling a scanning of large products with high speed. Using a stereometric arrangement of two or more cameras focusing on a certain line or on the product surface can decrease shadowing effects which can thusly increase measurement accuracy.

According to another advantageous embodiment said device can further comprise a control unit in electrical connection with at least said camera, said control unit can comprise control means and hue height mapping means adapted to at least control said camera and to map hue values of an image captured by said camera in order to obtain surface height information of said product.

According to another advantageous embodiment said device can further comprise adjustment means which can be controlled by said control means of said control unit for adjusting the colour spectrum width d of said multichromatic beam, particularly for adjusting an armature width w of said collimation unit, and/or for adjusting a beam splitting height b, a distance a between optical line of source and camera or said prism angle α of said spectrometer unit for adjusting height measuring sensitivity.

The measurement method of the tested product comprises the following steps of:
- calibrating the colour scale for [mm] of the height. This is performed by scanning the declination of the area where the angle of declination is known in advance with high precision. The image of this declined area will gradually acquire the whole spectrum and, at the same time, the height in the actual area will be known from the geometry of the declined area. The function of the dependence colour [R,G,B] = function (height) [mm] will be derived therefrom;
- Testing the composition of the scanned surface. The image produced by the camera is composed of individual images that display all parts on the surface of the tested product. Dimensions in the x and y-axis correspond to the actual dimensions of the recorded item. The colour reflection of the item corresponds to its height above the surface.
- Then, the software calculates (according to the function acquired during the calibration) the ascertained values of the colour components [R,G,B] of the individual pixels for the actual height (z-axis).

In the currently tested area, the software directly returns the values of the height (e.g. upper area of the condenser).

In other words, the inventive method for optically measuring the surface of a tested product, especially a PCB-product for reflow soldering paste inspection, using a device according to any of the aforementioned claims, comprises the following steps:
A beam of white light is emitted by said white light source that is rectified and collimated by said collimation unit into a parallel narrow beam passing trough said spectrometer unit, by which it is disintegrated into a colour spectrum. The reflection of said multichromatic beam on said product or components thereof is recorded by said camera. While moving said product in a scanning direction relative to said camera, an image is composed by said camera from individual images that displays all parts on the surface of said product and the image dimensions in a x and y-axis direction correspond to the actual dimensions of said product. At the same time, the hue values of the image, i.e. the values of colour components [R,G,B] of the individual pixels, are assigned to surface height values of said product.

According to another advantageous embodiment a hue height mapping of hue values of the colour spectrum to z surface height values can be calibrated by at least one gradual recording of a surface declination of a calibration body with a calibration angle β being known in advance with high precision and can be stored in a hue height map of a hue height mapping means. Preferably, the calibration body is a glass or ceramic board or disc or is made of an edged material.

By calibrating the measurement device by scanning a calibration body having a surface declined by a calibration angle β being known in advance, complicated calibration actions, such as high-precision mechanical adjustments of the device and complicated methods for determining surface height values, can be omitted. A complicated mechanical calibration being necessary for a resolution of 1 µm or less would lead to a highly expensive and complicated measuring action and is therefore not applicable for serial production methods. Surface height recognition is correlated with spectral hues of the light reflected from the surface of the product under testing. Since resolution of the camera pixels is limited, spectral components of the reflected light are usually mixed. The device can be calibrated by measuring a ramp function of a declined surface of a calibration body, being declined by a calibration angle β. Besides, a curved surface of the calibration body can also be used if the curvature function of the surface is known in advance. From scanning such a surface relief of a calibration body, a hue height map can be created, enabling the determination of a surface height from a measured hue value. For enhancing calibration quality of the device, a calibration routine can be repeated with different calibration angles and/or different calibration body widths, whereby an averaged hue height map can be calculated on the basis of the results of the different calibration routines. The different reflected spectral light components of the surface of the different calibration angles can be assigned to different z height values according to the bending function of the calibration body.

During a scanning process a direct evaluation of the height information can be extracted from the hue values of the image data produced by said camera (raw image data). Thus, a real-time z height profile of the surface of the tested camera can be produced, eliminating any measurement delays, whereby said real-time processing can be preferably achieved using a line-processing method.

During a calibration process an adaptation of the step width of the calibration body movement in x-axis scanning movement direction affects the calibration quality. Choosing a small step width or large step width determines the quality of calibration and z height measuring resolution, so that an SNR ratio (Signal Noise Ratio) can be optimized. For instance a surface ramp of a calibration body having the dimensions of 100mmx150mmx5mm (length x scanning width x height) can be scanned with a scanning step width of 20 µm, which leads to a scanning data quantity of 5.000 pixels x 7.500 pixels, which has to be stored as hue height map and which limits a z height resolution to 5000 height values. Reducing said step width to 1 µm leads to a z height accuracy resolution of 100.000 height values. A further modification of the surface of the calibration body, for instance following a predefined calibration surface function, can further enhance resolution accuracy. Using a precalibrated hue height map reduces data processing effort for further scanning processes, thus enhancing scanning time and reducing constraints in terms of the mechanical precision of the measurement device. In consequence, a serial production of measurement devices can be rendered less expensive and more easily feasible.

According to another advantageous embodiment the geometric position of said camera and said light source can be static for the whole duration of the scanning and/or a real-time hue height mapping can be performed during scanning using said hue height map.

According to another advantageous embodiment said camera can gradually record hue values line by line of a surface of said product while relatively moving said camera against said product in a scanning direction.

According to another advantageous embodiment said camera and said white light can be adjusted so that the beginning of said colour spectrum is mapped to zero height. Alternatively or additionally, the hue values recorded by said camera can be converted by means of a calibration function, preferably by a hue height map, into an actual surface height of the product or the components thereof.

According to another advantageous embodiment a 3D model of the product can be created based on measured x and y values of an image of said camera and z height values based on hue values of said image on the x and y axis.

According to another aspect of the present invention an application of an embodiment of an aforementioned device and an aforementioned method is proposed for measuring the dimensions of a product and/or for constructing a 3D model of said product, especially for measuring and inspecting the position and height of reflow soldering paste on a PCB product and/or for measuring the surface roughness of said product.

Surface roughness can be tested using a self-calibrated measurement device with high z height accuracy and a narrow width of the multichromatic light beam. As a calibration body a surface having a predefined value of surface roughness can be used instead of a calibration body having a declined surface by a calibration angle β. Thus, different calibration bodies with different surface roughness values have to be scanned in different z heights according to an embodiment of the measurement device for calibrating the device for surface roughness measurement. The extracted hue height map can be used for determining the surface roughness of surfaces in different z-height levels.

### Advantages of the subject-matter of the invention

The main advantages of the present invention can be seen in the simplicity, resistance and integration of the inventive solution.'The recording of the image together with the scanning of the item for geometric testing is carried out in one step. If it is not necessary to perform a test of the area for colour, it is possible to implement a 3D test directly onto the normal reading of the image which does not prolong the testing time. It is not necessary to recalculate the 3D model or to model it (as in the case of other systems), the height of the item is colour-recorded in the image and can be directly read. After incorporating the existing systems, no further actions requiring time are necessary, the invention has only minimum demands in terms of SW and it can be used as an additional module in already existing equipment.

The high variability and usability result from the easily adjustable scope of measurement by which it is possible to achieve the required measurement precision. The scope of measurement is set by the distance or by turning the optical prism when the width (and also the height) of the colour spectrum is changed so that the tested surface is lit. Therefore, it is possible to achieve the measurement precision for small items and components thereof (the measuring range is in tens of mm - e.g. electrotechnical components) in several micrometers.

The basis of this equipment are optical components, therefore, wearing or ageing are not encountered. The only component having a restricted service life is the source of light; however, there can be variations between hundreds to thousands hours of operation.

### Brief Description of the Drawings

The present invention together with the mentioned and other objects and advantages may best be understood from the following detailed description of the embodiments, but is not restricted to these embodiments.

In the drawings:
- Fig. 1 -: illustrates an example of a measurement device for inspection of an electronic component alignment on a PCB;
- Fig. 2 -: illustrates the example of a measurement device for inspection of a thin electronic component on a PCB corresponding to a red colour spectrum;
- Fig. 3 -: illustrates the example of a measurement device for inspection of a medium-sized electronic component on a PCB corresponding to a green colour spectrum;

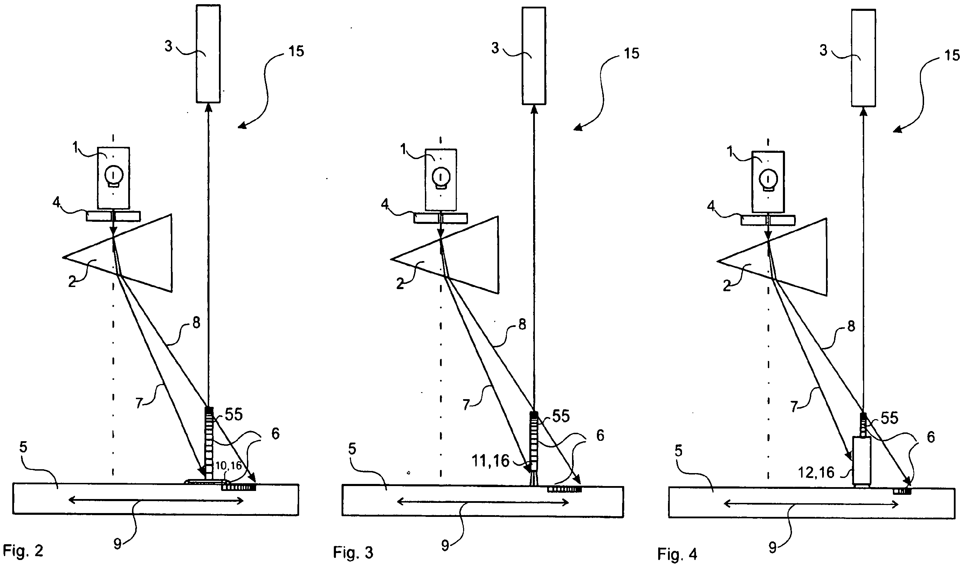

- Fig. 3 -: illustrates the example of a measurement device for inspection of a large electronic component on a PCB corresponding to a violet colour spectrum;

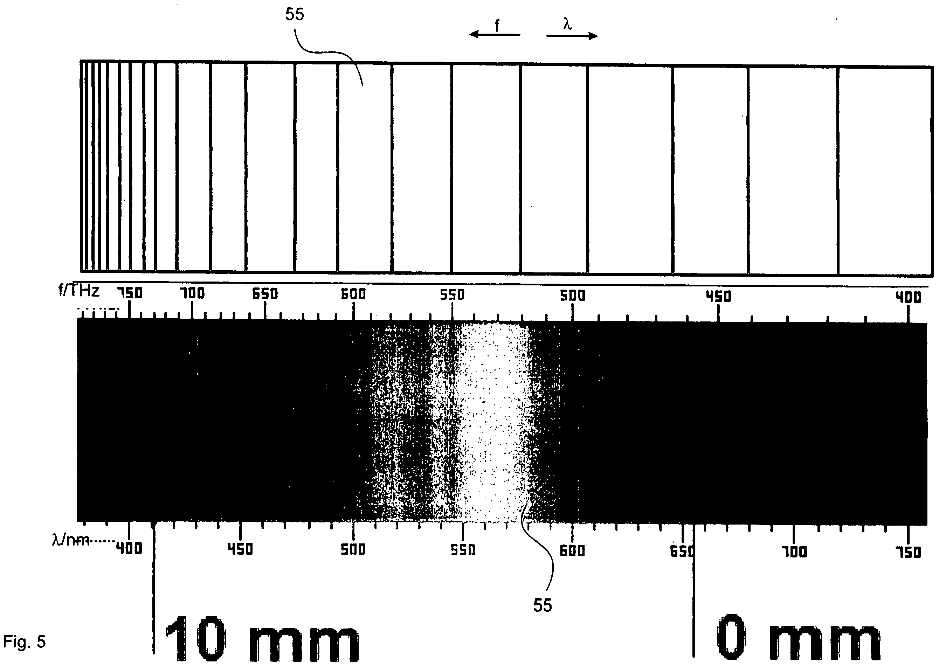

- Fig. 5 -: illustrates an example of a colour spectrum hue height map with a scale range of 0-10 mm;

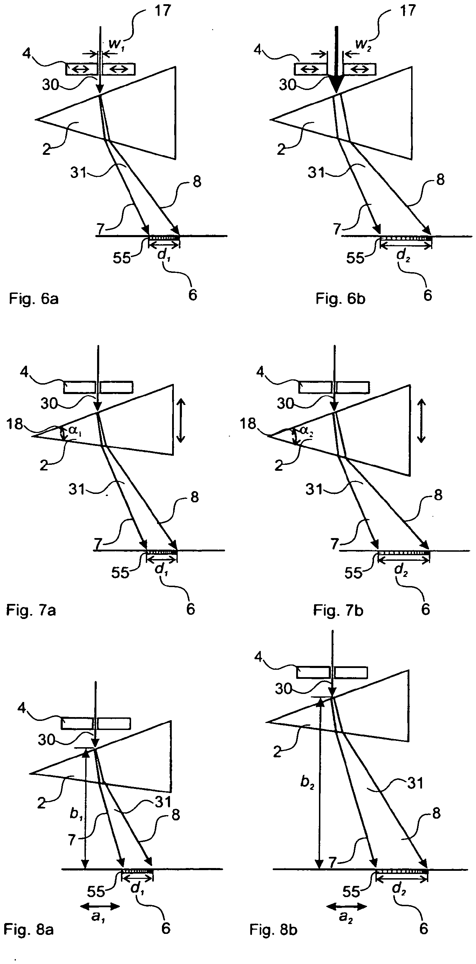

- Fig. 6 -: illustrates another example of a measurement device with an adjustable aperture means;
- Fig. 7 -: illustrates another example of a measurement with an adjustable optical prism;
- Fig. 8 -: illustrates another example of a measurement device with an adjustable height of the optical prism;

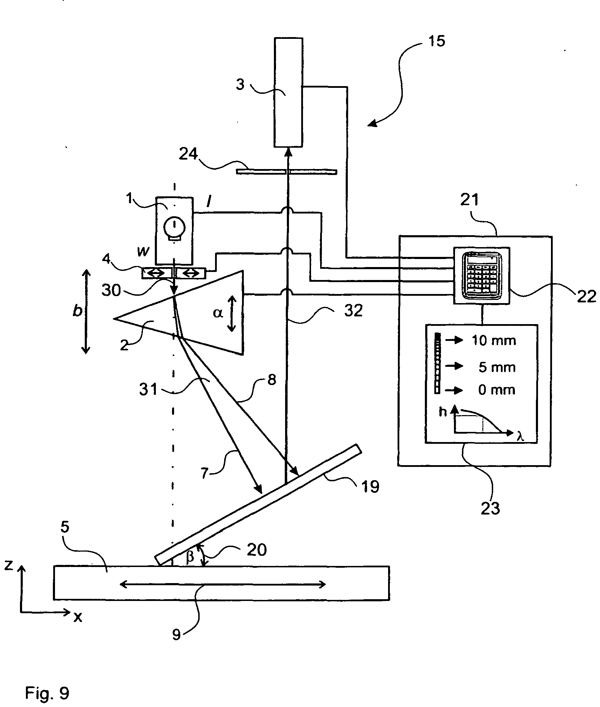

- Fig. 9 -: illustrates another example of a measurement device;

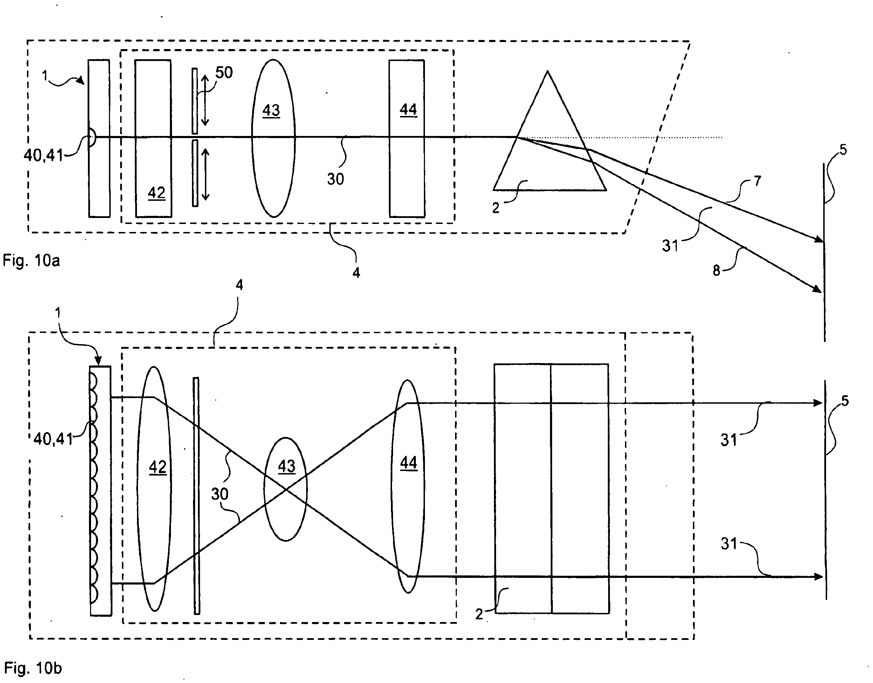

- Fig. 10 -: illustrates a light source and collimation unit configuration for an embodiment of a measurement device according to the present invention;

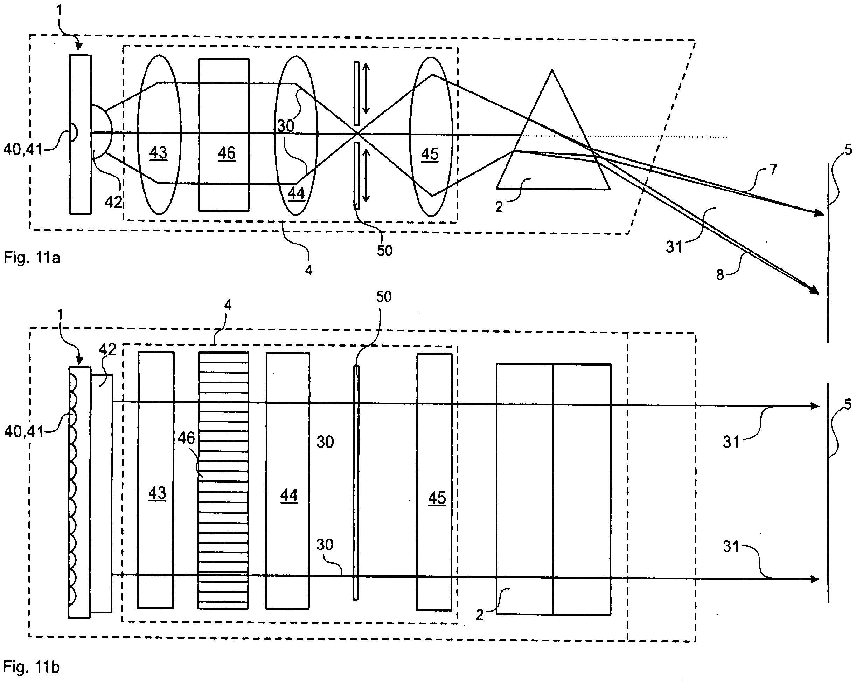

- Fig. 11 -: illustrates another light source and collimation unit configuration for an embodiment of a measurement device according to the present invention;

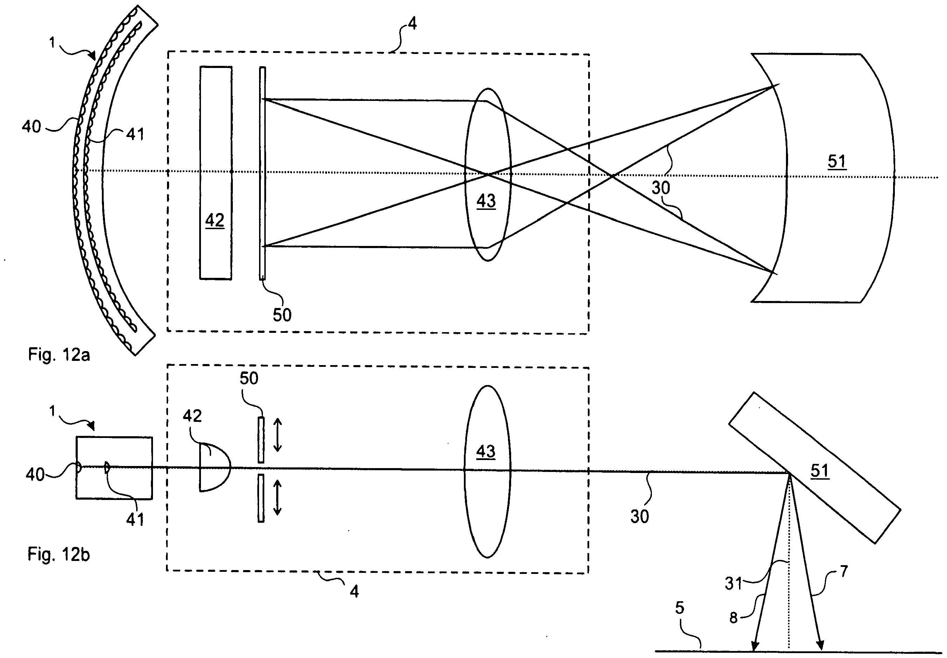

- Fig. 12 -: illustrates another light source and collimation unit configuration for an embodiment of a measurement device according the present invention.

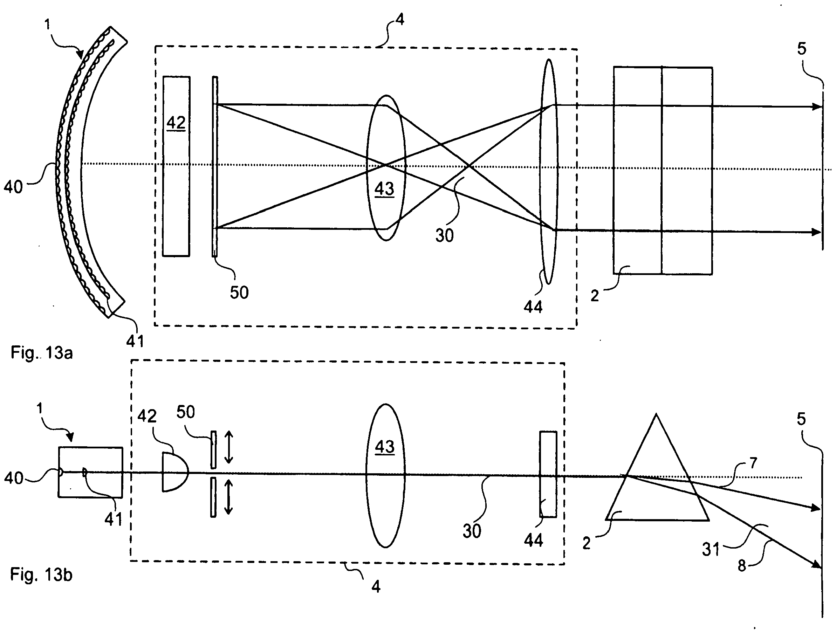

- Fig. 13 -: illustrates another light source and collimation unit configuration for an embodiment of a measurement device according to the present invention.

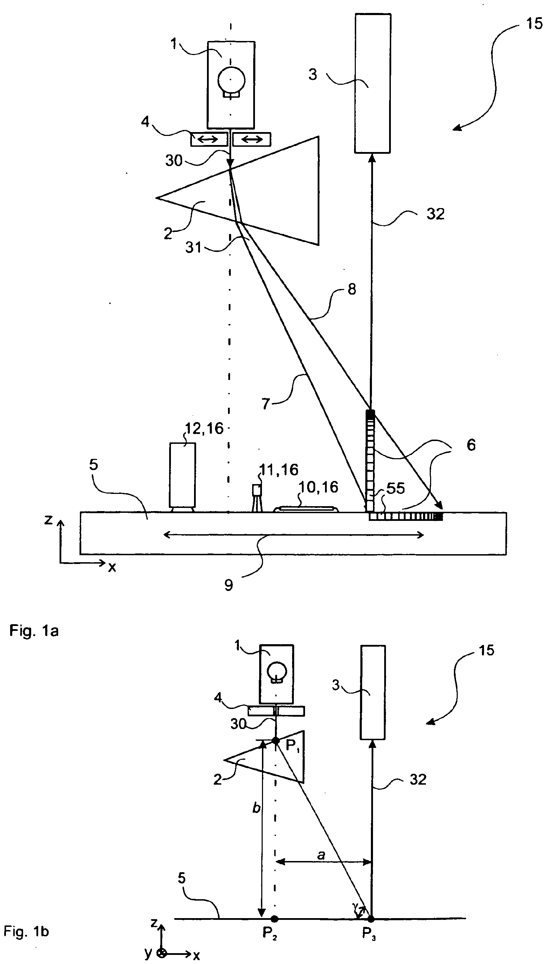

An example device 15 for measurement of a tested product for optically creating a 3D model is shown in Fig. 1 and comprises a white light source 1 with a continuous spectrum of white light, an optical unit 4 for rectifying and collimating the white light into a collimated beam of white light 30, an optical prism 2 for splitting said collimated beam of white light 30 into a into a multichromatic beam 31 and a RGB-line scanning camera 3. The light of the light source 1 is collimated by the optical unit 4 into a parallel, narrow beam 30 which then passes through the optical prism 2 which acts as a spectrometer unit and mediates the disintegration of the light into a spectrum 31 (Fig. 5). The collimated light 30 which enters the prism 2 contains all colour elements. After passing through the optical prism 2 the white light 30 disintegrates into individual colours 31 according to the law of light refraction. The individual components are monochromatic and are reflected as a spectrum 55 via a monochromatic light beam 32. The width d 6 of the spectrum 55 directly influences the distance resolution in the z-axis. The line camera 3 (single row), which is preferably an RGB or at least a two colour camera 3 gradually scans a surface of the tested product 5 line by line by which it is moved in a x-axis scanning direction 9. The geometric position of the camera 3 and the reflected light 32 is the same during the whole period of scanning. The camera 3 and the reflected light 32 are adjusted to zero height (ground) so that the camera 3 displays the beginning 7 of the spectrum 55, i.e. the red colour. All non-zero heights are displayed in another colour as they are in the colour spectrum 55. For adjusting the width d 6 of the colour spectrum 55 the aperture size of the collimation unit 4 is adjustable, thus adjusting resolution quality and measurement range of z values. The tested product is a PCB 5 on which several electronic components 16, such as capacitors, transistors or ICs, are arranged. The measurement device 15 inspects a correct alignment of the electronic components 16.

The manner of measurement of the tested product comprises several steps. The first step is the calibration of the colour spectrum for a distance conversion of the height. This is performed by scanning the declination angle β 20 of a surface area of a calibration body 19 where the angle of the declination 20 is known in advance with high precision - see Fig. 9. The image of this declined area will gradually continue along the whole spectrum 55 and, at the same time, the height in the actual area will be known from the geometry of the declined height. The function of the dependence of the colour [R,G,B] = finction(height) [mm/µm] is derived therefrom.

A further step is the testing of the composition of the scanned surface. The image produced by the camera 3 is composed of individual images that display all parts on the surface of the tested product 5. Dimensions in the x and y-axis correspond to the actual dimensions of the recorded product 5. The colour reflection 32 of the product 5 corresponds to its height above the surface. Then, a software calculates (according to the function acquired during the calibration) the ascertained values of the colour components [R,G,B] of the individual pixels for the actual height (z-axis). In the actual tested area, the software directly returns the values of the height (e.g. the upper area of the condenser).

Fig. 1b schematically illustrates a special arrangement of camera 3, white light source 1, collimation unit 4, spectrometer unit 2 and product under test 5. The white light source 1 emits white light which is collimated by the collimation unit 4 into a collimated white light beam 30. The collimated white light beam 30 is split into a multichromatic light beam 31 by the spectrometer unit 2, whereby the center of the multichromatic light beam 31 hits the surface of the product 5 at point P₃. At point P₃, a monochromatic light beam 32 is reflected perpendicular to a flat surface of the product under testing 5 into a lens of a camera 3. An optical axis of white light source 1 hits the surface of the product 5 at point P₂. Point P₁ defines an entrance point of the collimated light beam 30 into spectrometer unit 2, where the collimated white light beam 30 is refracted and expanded to a multichromatic light beam 31. Points P₁, P₂ and P₃ define a right angle triangle, whereby an angle γ defines the incidence angle with which the multichromatic light beam 31 hits the surface of the product. This angle γ depends on the height *b* of the spectrometer unit 2 above the surface of the product 5 (distance between Points P₁ and P₂) and a distance *a* between the optical axis of white light source 1 and camera 3 (distance between Points P₂ and P₃). By varying *a* and *b*, which means varying incident angle γ, a measurement resolution of surface values can be adjusted.

Figs. 2, 3 and 4 schematically display a measurement of an electronic component 16 being mounted on a PCB board 5, while scanning the PCB board 5 in a scanning direction 9. Fig. 2 illustrates the reflection of a spectrum 55 on a small-sized electronic component 16, such as an IC (Integrated Circuit). The height of the electronic component 16 is small, so that a monochromatic light (red light) near the beginning of the colour spectrum 7 is reflected.

Fig. 3 illustrates a reflection of a medium-sized electronic component 16, e.g. a transistor, whereby a monochromatic colour from the middle of the spectrum, e.g. a green colour, is reflected and is detected by the camera 3. Fig. 4 illustrates a reflection of a multichromatic light beam of a large electronic component 16, such as a capacitor. A violet light, near the end of the colour spectrum 8 is reflected into camera 3. As such, from different hue values (red, green, violet) a height of an electronic component 16 mounted on a PCB 5 can easily be measured.

Fig. 5 displays a hue height map for use in a measurement device. The hue height map correlates a height range of 0 to 10 mm to a spectral light range between 460 to 740 THz (420 to 660 nm wavelength). Such a correlation between wavelength/frequency and metric dimensions can be extracted by a calibration routine according to an embodiment of the inventive method.

Figs. 6, 7 and 8 illustrate several options of varying the width of colour spectrum 55 for controlling measurement resolution of a measurement device 15. Fig. 6 illustrates an arrangement wherein an aperture size of collimation unit 4 is varied between an aperture size *w*₁ to an aperture size *w*₂. In consequence, the width of the collimated white light beam 30 and the spreading angle of the multichromatic light beam 31 are varied and thus the width 6 of the spectrum 55 changes from length d I to length d 2.

Fig. 7 displays a similar effect by varying an opening angle α 18 of an optical prism 2. In Fig. 7a an optical prism has an opening angle α₁, resulting in a width d 16 of spectrometer 55. By varying the opening angle α₁ to a value α₂, a width 6 of spectrometer 55 changes for *d*₁ to *d*₂. An optical prism having a variable opening angle α 18 can be provided by using a liquid optical prism, whereby the opening angle α 18 can be adjusted by different electrostatic potentials or by mechanical means or other techniques known from the state of the art.

Fig. 8 illustrates another measurement device 15, wherein a height b between a surface of a tested product 5 and a spectrometer unit 2 can be varied. By varying a distance *b*₁ to a distance *b*₂, the opening angle of multichromatic light beam 31 changes, thus resulting in a variation of width d 6 of spectrometer 55 from *d*₁ to *d*₂. According to the height variation from *b*₁ to *b*₂ of spectrometer 2 over the surface of a tested product 5, a distance a between the optical axis of white light source 1 and camera 3 should also be changed from *a*₁ to *a*₂, thus leaving incident angle γ constant.

Fig. 9 illustrates another measurement device 15, wherein a calibration routine is performed. On top of a product surface 5, a calibration body 19, e.g. a calibration board 19, is mounted having a declination angle β 20 being adjustable in relation to a horizontal surface of measured product 5. While moving the declined surface of calibration body 19 in a scanning direction 9, the white light source 1 produces a collimated beam of light 30, which is collimated by a collimation unit 4, and which is split into a multichromatic light beam 31 by spectrometer unit 2. Spectrometer unit 2 has a variable prism angle α and collimation unit 4 can change an aperture size w for adjusting the opening angle of the multichromatic light beam 31 to influence height measurement resolution accuracy. Due to movement of calibration body 19 in a scanning movement direction 9, different monochromatic light beams 32 are reflected towards camera 3, whereby camera 3 is equipped with a camera aperture unit 24 for eliminating parasitic scattered light. The camera 3 scans the light in correlation with the scanning movement 9 of calibration body 19 having a declined surface with calibration angle β 20 and transfers image data to a control unit 21. The control unit 21 comprises control means 22 which controls intensity/brightness of the white light source 1, aperture width w of collimation unit 4 and prism angle α 18 of spectrometer unit 2. Hue data received by camera 3 are stored in a hue-height map 20 of a hue-height mapping means 23, whereby different colours are associated with different *z*-height values being known form calibration angle β and the dimensions of calibration body 19.

Fig. 10 illustrates an ensemble of a white light source 1, a collimation unit 4 and an optical prism 2 for producing a beam of multichromatic light 31 having a beginning of a colour spectrum 7 (red light) and an end of a colour spectrum 8 (violet light) hitting a surface of a product 5 under testing. Fig 10a displays a side view and Fig. 10b a top view of said ensemble. The white light source 1 comprises a stripe of LEDs 40 (Light Emitting Diode), whereby multiple microlenses 41 rectify the diffuse white light emitted by the LEDs 40 into a parallel light beam. The collimation unit 4 comprises a first lens 42, a second lens 43 and a fourth lens 44 as well as an aperture means 50 which can be a slit diaphragm. The opening width w of the slit diaphragm 50 is variable such that the width of the collimated white light beam 30 can be adjusted. The collimation unit 4 converts the white light beam emitted by the white light source 1 into a collimated white light beam 30 having parallel beams of white light of all different colour values. The optical prism 2 divides the collimated white light beam 30 into a multichromatic beam 31 of a spectrum 55 having an opening width b.

Fig. 11 illustrates another embodiment of a white light source 1, a collimation unit 4 and an optical prism 2 for forming a multichromatic beam of light 31. Fig 11 a displays a side view and Fig. 11b a top view of said ensemble. The white light source 1 comprises an LED stripe 40 equipped with microlenses 41 and a first lens 42. The collimation unit 4 comprises multiple lenses 43, 44 and 45 for suppressing parallax effects and further comprises an aperture unit 50 having a variable opening width and a collimation grid 46 for collimating the diffuse white light beam emitted by white light source 1. The collimated white light beam 30 is converted into an rainbow-beam 31 of multichromatic colours by a prism 2.

Fig. 12 illustrates another embodiment of a white light source 1, a collimation unit 4 and a spectrometer unit, wherein the white light source 1 comprises a bended LED stripe comprising a banded stripe of microlenses 41 for pre-rectifying emitted white LED light. Fig 12a displays a top view and Fig. 12b a side view of said ensemble. The light of the bended light source 1 enters a collimation unit 4 and is rectified by a first cylinder lens 42, and falls through an aperture unit 50 having an adjustable opening width and finally focussed by an elliptical second lens 43 before leaving said collomination unit 4. The collimated beam 30 of white light is then reflected and converted into a multichromatic beam of light 31 by an optical diffraction grading 5 1. A surface of a tested product 5 is arranged in parallel to the optical axis of collimated white light beam 30 beneath said optical diffraction grading 51.

Finally, Fig. 13 illustrates a similar embodiment of a white light source 1, a collimation unit 4 and a spectrometer unit, whereby the spectrometer unit is an optical prism 2. Fig 13a displays a top view and Fig. 13b a side view of said ensemble. The white light source 1 comprises a bended stripe of LEDs 40 equipped with a bended stripe of microlenses 41 for pre-rectifying an beam of white light 30 which is collimated by a collimation unit 4. The collimation unit 4 comprises a cylinder lens 42, an aperture means 50, which is a slit diaphragm having a variable opening width, and an elliptical lens 43. Finally, the collimation unit 4 comprises a third lens 44 at the optical end thereof and said collimated beam of light 30 enters an optical prism 2 for being diffracted into a beam of multichromatic light 31 hitting the surface of a product under testing 5.

Another embodiment of the device can be used for testing electronic boards containing electronic components:
- The tester 15 is calibrated so that zero height is defined on the surface of the mounted (master) board 5, so that after scanning, the board (ground) will be displayed in a dark red colour (beginning 7 of the spectrum). The measuring range is selected according to the highest measured part 12 (violet).
- In the testing plant the position is defined along with the height and the tolerance of the measured product 5 (of the board).
- After passing the board through the line scanning camera 3 the individual components thereof are displayed in colour depending on their height.
- The software, using the calibration function, transfers colour shades to the values of the height given in millimetres.
- In the tested areas the actual height of the component is evaluated and with respect to the specified tolerance the output is in the form of information indicative of whether the tested product 5, the board as a whole (or its individual components) are defective or not.

Another embodiment of the device can be used for testing board surfaces or surfaces of solar cell products:
- The tester 15 its calibrated so that the surface in a normal acceptable status will be displayed after scanning in the colour which is usually approximately located in the middle of the spectrum (e.g. green).
- The measuring range is selected, i.e. the maximum (largest) and minimum (smallest) deviations which can occur on the tested board (bending of the board, surface defects, cracks, abrasions, sediments, etc.). The smallest deviation will be displayed in red colour and the largest will be displayed violet colour.
- The whole surface of the calibration body can be defined as a tested area and the deviation tolerance of deviation is selected.
- The board can be scanned by means of a line scanning camera 3.
- Using the calibration function, the software can convert the colour shades into the values of the height given in millimetres or µ-meters.
- It is evaluated whether any area has larger deviations than predetermined by the permitted tolerance. The output can be information representative of the aspect of whether the tested product 5 (board) is defective or not.

### Industrial applicability

The technical solution to the invention can be particularly used for approximate or target inspection of the geometry and measurement of the distance of individual products or components thereof, particularly where there is the necessity to optically measure the distance between the sensor and the tested part, i.e. in the direction in which the change is not reflected on the image in the normal status.

### Reference Signs:

- 1 -: white light source
- 2 -: optical prism
- 3 -: camera
- 4 -: collimation unit
- 5 -: measured product (e.g. PCB)
- 6 -: width of the colour spectrum
- 7 -: beginning of the colour spectrum
- 8 -: of the colour spectrum end
- 9 -: scanning movement direction
- 10 -: component with the height corresponding to a red colour of the white light spectrum
- 11 -: component with the height corresponding to a green colour of the white light spectrum
- 12 -: component with the height corresponding to a violet colour of the white light spectrum
- 15 -: measurement device
- 16 -: electronic component
- 17 -: aperture width of collimation unit
- 18 -: variable prism angle α
- 19 -: calibration body
- 20 -: calibration angle β
- 21 -: control unit
- 22 -: control means
- 23 -: hue height mapping means
- 24 -: camera aperture unit
- 30 -: collimated white light beam
- 31 -: multichromatic light beam
- 32 -: reflected monochromatic light beam
- 40 -: LED stripe
- 41 -: microlens
- 42 -: first lens
- 43 -: second lens
- 44 -: third lens
- 45 -: fourth lens
- 46 -: collimation grid
- 50 -: aperture means
- 51 -: optical diffraction grading
- 55 -: colour spectrum

## Claims

1. Device (10) for optically measuring the surface of a tested product (5), especially a PCB product for reflow soldering paste inspection, comprising at least one white light source (1) for emitting a beam of white light, at least one collimation unit (4) for collimating said beam of white light (30), at least one spectrometer unit, preferably an optical prism (2) or an optical diffraction grading (51), for splitting said beam of white light (30) into a beam of multichromatic light (31) being directed onto said tested product (5) under a predetermined incident angle γ, and at least one camera (3) for recording a reflected beam of monochromatic light (32) of said tested product (5), the device being arranged such that a z-axis surface height information of said tested product (5) can be extracted from a hue value of said reflected beam of monochromatic light (32) while relatively moving said tested product (5) in a x-axis scanning direction (9),
**characterized by**
said white light source (1) is an LED stripe (40), which is adapted for producing a white light stripbeam, wherein at least one microlens (41) is optically coupled to at least one LED for prerectification of said beam of white light (30), and said collimation unit (4) is adapted to collimate said white light beam (30) in 360° with a collimation quality af 2° or less and to form a white light stripbeam being perpendicular to said scanning direction (9), and comprises at least one lens (42, 43, 44, 45), preferably a cylinder lens (42) and at least one aperture means (50), preferably an adjustable slit diaphragm aperture.

2. Device according to claim 1, whereby said white light source (1) has a continuous spectrum (55) and/or the frequency-bandwidth of the spectrum (55) is variable, preferably in a wavelength range of 350-850 nm and/or the intensity of the white light source (1) is adjustable, preferably by dimming of said light source (1) or by selectively switching two or more light sources (1) on or off in parallel.

3. Device (10) according to any of the aforementioned claims, whereby multiple LEDs of an LED stripe (40) can be selectively switched either on or off for enhancing intensity and/or length of white light beam (30) in a y-axis direction perpendicular to said scanning direction (9).

4. Device (10) according to any of the aforementioned claims, further comprising a scanning transportation means for relatively transporting said tested product (5) or said light source (1), a spectrometer unit, a collimation unit (4) and a camera (3) in a scanning direction (9).

5. Device according to any of the aforementioned claims, whereby said camera (3) is a line scanning camera, preferably comprising a camera aperture unit (24) and/or a parallax lens unit for reducing parallax effects, especially a cylinder lens or round lens unit, for receiving a beam of monochromatic light (32) reflected from said beam of multichromatic light (31) by said tested product (5), and/or said camera (3) is a digital camera with at least 8 Bit hue resolution, preferably an adjustable 10, 12 Bit or higher hue resolution, and/or said camera (3) comprises two or more line scanning rows, each row comprising a colour filter for increasing a hue sensitivity, and/or said camera (3) comprises at least one grey or black/white scanning row for enhancing scanning quality, or said camera (3) is an area scanning camera, whereby single or multiple scanning rows of said scanning area can be extracted for hue height information processing.

6. Device according to any of the aforementioned claims, comprising at least two or more cameras (3) arranged in a y-axis direction perpendicular to said x scanning direction (9) for parallel scanning, thus enhancing scanning width of said product (5) and/or said cameras (3) being stereometrically arranged for 3D-scanning of said product (5) for reducing shadowing and illumination effects.

7. Device according to any of the aforementioned claims, further comprising a control unit (21) in electrical connection with at least said camera (3), said control unit (21) comprises control means (22) and hue height mapping means (23) adapted to at least control said camera (3) and to map hue values of an image captured by said camera (3) to a surface height information of said product (5).

8. Device according to claim 7, further comprising adjustment means being controllable by said control means (22) of said control unit (21) for adjusting the colour spectrum width d (6) of said multichromatic beam (31), particularly for adjusting an armature width w (17) of said collimation unit (4), and/or for adjusting a beam splitting height b, distance a between optical line of source (1) and camera (3) or said prism angle α of said spectrometer unit for adjusting height measuring sensitivity.

9. Method for optically surface measuring of a tested product (5), especially a PCB-product for reflow soldering paste inspection using a device according to any of the aforementioned claims,
wherein a beam of white light is emitted by said white light source (1) and is rectified and collimated by said collimation unit (4) into a parallel narrow beam (30) passing trough said spectrometer unit (2, 51), by which it is disintegrated into a colour spectrum (55) whose reflection on said product (5) or components thereof is recorded by said camera (3) while moving said product (5) in a scanning direction (9) relative to said camera (5), so that an image composed by said camera (3) from individual images displays all parts on the surface of said product (5) and the image dimensions in x and y-axis direction correspond to the actual dimensions of said product (5), and, at the same time, the hue values of the image, i.e. the values of colour part [R,G,B] of the individual pixels are assigned to surface height values of said product (5).

10. Method according to claim 9, wherein a hue height mapping of hue values of the colour spectrum (55) to z surface height values is calibrated by at least one gradual recording of a surface declination of a calibration body (19) with a calibration angle β (20) being known in advance with high precision and storing a hue height map in a hue height mapping means (23).

11. Method according to any of the preceding method claims,
wherein the geometric position of said camera (3) and said light source (1) is static during the whole time of scanning and/or a real-time hue height mapping is performed during scanning using said hue height map.

12. Method according to any of the preceding method claims,
wherein said camera (3) gradually records hue values line by line of a surface of said product (5) while relatively moving said camera (3) against said product (5) in a scanning direction (9).

13. Method according to any of the preceding method claims,
wherein said camera (3) and said white light (1) are adjusted so that the beginning (7) of said colour spectrum (55) is mapped to zero height and/or the hue values recorded by said camera (3) are converted by means of a calibration function, preferably by a hue height map to an actual surface height of the product (5) or components thereof.

14. Method according to any of the preceding method claims,
wherein a 3D model of the product 5 is created based on measured x and y values of an image of said camera (3) and a z height value based on hue values of said image on the x and y-axis.

15. Method according to any of the preceding method claims wherein the dimensions of a product (5), especially the position and height of reflow soldering paste on a PCB or solar cell product and/or the surface roughness of said product (5), are measured.

## Patentansprüche

1. Vorrichtung (10) zur optischen Vermessung der Oberfläche eines zu untersuchenden Produkts (5), insbesondere eines PCB-Produkts zur Reflow-Lotpasteninspektion, umfassend zumindest eine Weißlichtquelle (1) zur Abstrahlung eines Weißlichtstrahls, zumindest eine Kollimationseinrichtung (4) zur Kollimation des Weißlichtstrahls (30), zumindest eine Spektrometereinrichtung, vorzugweise ein optisches Prisma (2) oder ein optisches Gitter (51), zur Aufspaltung des Weißliclrtstrahls (30) in einen multichromatischen Lichtstrahl (31), der unter einem vorgegebenen Einfallswinkel γ auf das zu untersuchende Produkt (5) gerichtet ist, und zumindest eine Kamera (3) zur Aufnahme eines reflektierten monochromatischen Lichtstrahls (32) des zu untersuchenden Produkts (5), wobei die Vorrichtung ausgelegt ist, um eine Z-Achsen-Oberflächenhöheninformation des zu testenden Produkts (5) aus einem Farbwert des reflektierten monochromatischen Lichtstrahls (32) zu extrahieren, während das zu untersuchende Produkt (5) in einer X-Achsen-Scanrichtung (9) relativ bewegt wird, dadurch gekenntzeichnet, dass
die Weißlichtquelle (1) ein LED-Band (40) ist, das zur Erzeugung eines Weißlichtbandstrahls ausgelegt ist, wobei zur Vorausrichtung des Weißlichtstrahls (30) zumindest eine Mikrolinse (41) mit zumindest einer LED optisch gekoppelt ist, und wobei die Kollimationseinrichtung (4) zur 360°-Kollimation des Weißliclrtstrahls (30) mit einem Kollimationsgrad von 2° oder weniger und zur Bildung eines Weißlichtbandstrahls, der senkrecht zur Scanrichtung (9) ausgerichtet ist, ausgelegt ist, und zumindest eine Linse (42, 43, 44, 45), vorzugsweise eine Zylinderlinse (42), und zumindest ein Blendenmittel (50), vorzugsweise eine verstellbare Schlitzblende, umfasst.

2. Vorrichtung nach Anspruch 1, wobei die Weißlichtquelle (1) ein kontinuierliches Spektrum (55) aufweist und/oder die Frequenz-Bandbreite des Spektrums (55) variabel ist, vorzugsweise in einem Wellenlängenbereich von 350-850 nm, und/oder die Helligkeit der Weißlichtquelle (1) einstellbar ist, vorzugsweise durch Dimmen der Lichtquelle (1) oder durch selektiv paralleles Ein- oder Ausschalten zweier oder mehrerer Lichtquellen (1),

3. Vorrichtung (10) nach einem der vorgenannten Ansprüche, wobei mehrere LEDs eines LED-Bandes (40) zur Erhöhung der Helligkeit und/oder der Länge des Weißlichtstrahls (3) in einer Y-Achsenrichtung senkrecht zur Scanrichtung (9) selektiv an- oder ausgeschaltet werden können.

4. Vorrichtung (10) nach einem der vorgenannten Anspruche, ferner umfassend ein Scan-Transportmittel zum Transport des zu untersuchenden Produkts (5) oder der Lichtquelle (1), eimer Spektrometereinrichtung, einer Kollintatiunseinrichtung (4) und einer Kamera (3) in eine Scanrichtung (9) relativ zueinander.

5. Vorrichtung nach einem der vorgenannten Ansprüche, wobei die Kamera (3) eine Zeilenkamera ist, vorzugsweise umfassend eine Kamerablendeneinrichtung (24) und/oder eine Parallaxenlinseneinrichtung zur Reduzierung von Parallaxeraeffekten, insbesondere eine Zylinderlinsen- oder Rundlinseneinrichtung, zur Aufnahme eines monochromatischen Lichtstrahls (32), der von dem durch das zu untersuchende Produkt (5) reflektierten multichromatischen Lichtstrahl (31) stammt, und/oder die Kamera (3) eine Digitalkamera mit einer 8-Bit-Mindestfarbauflösung, vorzugweise mit einer einstellbaren 10- oder 12-Bit-Farbauflösung oder einer höheren Farbauflösung, ist und/oder die Kamera (3) zwei oder mehrere Zeilenscanreihen umfasst, wobei jede Reihe einen Farbfilter zur Erhöhung der Farbempfindlichkeit umfasst, und/oder die Kamera (3) zumindest eine Grau- oder Schwarz/Weiß-Scanreihe zur Erhöhung der Scanqualität umfasst, oder die Kamera (3) eine Flächenscankamera ist, wobei einzelne oder mehrere Scanreihen der Scanfläche zur Farbhöheninformationsverarbeitung extrahiert werten können.

6. Vorrichtung nach einem der vorgenannten Ansprüche, umfassend zumindest zwei oder mehrere Kameras (3), die zum Parallelscannen in einer Y-Achsenrichtung senkrecht zur X-Scanrichtung (9) angeordnet sind, wodurch die Scanbreite des Produkts (5) erhöht wird, und/oder die Kameras (3) zum 3D-Scannen des Produkts (5) Stereometrisch angeordnet sind, um Schatten- und Beleuchtungseffekte zu reduzieren.

7. Vorrichtung nach einem der vorgenannten Ansprüche, ferner umfassend eine Steuereinrichtung (21), die zumindest mit der Kamera (3) in elektrische Verbindung steht, wobei die Steuereinrichtung (21) Steuermittel und Farbhöhen-Abbildungsmittel (23) umfasst, die zumindest zur Steuerung der Kamera (3) und zur Abbildung der Farbwerte eines durch die Kamera (3) aufgenommenen Bildes mit einer Oberflächenhöheninformation des Produkts (5) eingerichtet sind.

8. Vorrichtung nach Anspruch 7, ferner umfassend Einstellmittel, die durch die Steuermittel (22) der Steuereinrichtung (21) ansteuerbar sind, um die Farbspektrumsweite *d* (6) des multichromatischen Lichtstrahls (31) einzustellen, insbesondere um eine Blendenbreite w (17) der Kollimationseinrichtung (4) einzustellen, und/oder die Strahlaufspaltungsweite *b*, den Abstand *a* zwischen der optischen Linie der Quelle (1) und der Kamera (3) oder den Prismenwinkel α der Spektrometereinrichtung zur Anpassung der Höhemessungsempfindlichkeit einzustellen.

9. Verfahren zur optischen Vermessung der Oberfläche eines zu untersuchenden Produkts (5), insbesondere eines PCB-Produkts zur Reflow-Lotpasteninspektion unter Verwendung einer Vorrichtung nach einem der vorgenannten Ansprüche, wobei ein Weißlichtstrahl von der Weißlichtquelle (1) abgestrahlt und von der Kollimationseinrichtung (4) zu einem parallelen enggebündelten Lichtstrahl (30) ausgerichtet und kollimiert wird, der durch die Spektrometereinrichtung (2, 51) fällt, die den Lichtstrahl (30) in ein Farbspektrum (55) zerlegt, dessen Reflektion auf dem Produkt (5) oder Bestandteilen davon von der Kamera (3) aufgenommen wird, indem das Produkt (5) in einer Scanrichtung (9) relativ zur Kamera (5) bewegt wird, so dass ein von der Kamera (3) aus Einzelbildern zusammengesetztes Bild alle Bestandteile auf der Oberfläche des Produkts (5) darstellt, und die Bildabmessungen in der X- und Y-Achsenrichtung den tatsächlichen Abmessungen des Produkts (5) entsprechen, und gleichzeitig die Farbwerte des Bildes, d.h. die Werte der [R/G/B]-Farbanteile der einzelnen Bildpunkte, Oberflächenhöhenwerten des Produkts (5) zugeordnet werden.

10. Verfahren nach Anspruch 9, wobei die Farbhöhen-Zuordnung der Farbwerte des Farbspektrums (55) zu Z-Oberflächenhöhenwerten durch zumindest eine graduelle Aufnahme einer Oberflächenneigung eines Kalibrierungskörpers (19) unter einem Kalibrierungswinkel β (20), der mit hoher Genauigkeit vorgegeben ist, kalibriert wird, und ein Farbhöhenkennfeld in einem Farbhöhenzuordnungsmittel (23) gespeichert wird.

11. Verfahren nach einem der vorgenannten Verfahrensansprüche, wobei die geometrische Position der Kamera (3) und der Lichtquelle (1) während der gesamten Scandauer statisch ist und/oder eine Echtzeit-Farbhöhenzuordnung während dem Scanvorgang unter Verwendung des Farbhöhenkennfelds durchgeführt wird.

12. Verfahren nach einem der vorgenannten Verfahrensansprüche, wobei die Kamera (3) Farbwerte von einer Oberfläche des Produkts (5) graduell Zeile für Zeile aufnimmt, indem die Kamera (3) gegenüber dem Produkt (5) in eine Scanrichtung (9) relativ bewegt wird.

13. Verfahren nach einem der vorgenannten Verfahrensansprüche, wobei die Kamera (3) und das Weißlicht (1) so eingestellt sind, dass der Anfang (7) des Farbspektrums (55) mit Nullhöhe abgebildet ist und/oder die von der Kamera (3) aufgenommenen Farbwerte mittels einer Kalibrierfunktion, vorzugweise einem Farbhöhenkennfeld in eine tatsächliche Oberflächenhöhe des Produkts (5) oder Bestandteilen davon, umgewandelt werden.

14. Verfahren nach einem der vorgenannten Verfahrensansprüche, wobei ein 3D-Model des Produkts (5) auf Basis gemessener X- und Y-Werte eines Bildes der Kamera (3) und ein Z-Höhenwert auf Basis der Farbwerte des Bildes entlang der X- und Y-Achse erstellt wird.

15. Verfahren nach einem der vorgenannten Verfahrensansprüche, wobei die Abmessungen eines Produkts (5), insbesondere die Position und die Höhe der Reflow-Lotpaste auf einem PCB- oder Solarzellenprodukt, und/oder die Oberflächenrauhigkeit des Produkts (5) gemessen werden.

## Revendications

1. Dispositif (10) pour mesurer optiquement la surface d'un produit testé (5), notamment un produit de type carte de circuit imprimé, afin d'inspecter la pâte de brasage par refusion, comprenant au moins une source de lumière blanche (1) afin d'émettre un faisceau de lumière blanche, au moins une unité de collimation (4) afin de collimater ledit faisceau de lumière blanche (30), au moins une unité à spectromètre, de préférence un prisme optique (2) ou un réseau de diffraction optique (51), afin de diviseur ledit faisceau de lumière blanche (30) en un faisceau de lumière polychrome (31) dirigé vers ledit produit testé (5) à un angle d'incidence prédéfini Y, et au moins une caméra (3) afin d'enregistrer un faisceau de lumière monochrome réfléchi (32) depuis ledit produit testé (5), lequel dispositif est disposé de sorte que des informations de hauteur de surface d'axe Z dudit produit testé (5) puissent être extraites à partir d'une valeur de nuance dudit faisceau réfléchi de lumière monochrome (32) tout en déplaçant relativement ledit produit testé (5) dans une direction de balayage d'axe x (9),
**caractérisé en ce que**
ladite source de lumière blanche (1) consiste en une barrette de DEL (40) qui est conçue pour produire un faisceau en bande de lumière blanche, au moins une microlentille (41) étant couplée optiquement à au moins une DEL en vue d'un pré-redressement dudit faisceau de lumière blanche (30), et ladite unité de collimation (4) étant conçue pour collimateur ledit faisceau de lumière blanche (30) à 360° avec une qualité de collimation de 2° ou moins et pour former un faisceau en bande de lumière blanche perpendiculaire à ladite direction de balayage (9), et comprend au moins une lentille (42, 43, 44, 45), de préférence une lentille cylindrique (42), et au moins un moyen d'ouverture (50), de préférence une ouverture à diaphragme à fente réglable.

2. Dispositif selon la revendication 1, dans lequel ladite source de lumière blanche (1) possède un spectre continu (55) et/ou la largeur de bande de fréquence du spectre (55) est variable, de préférence dans une plage de longueurs d'onde de 350 à 850 nm, et/ou l'intensité de la source de lumière blanche (1) est réglable, de préférence en atténuant ladite source de lumière (1) ou en allumant ou en éteignant sélectivement deux sources de lumière (1) ou plus en parallèle.

3. Dispositif (1.0) selon l'une quelconque des revendications susmentionnées, dans lequel de multiples DEL d'une barrette de DEL (40) peuvent être allumées ou éteintes sélectivement afin d'augmenter l'intensité et/ou la longueur du faisceau de lumière blanche (30) dans le sens d'un axe y perpendiculaire à ladite direction de balayage (9).

4. Dispositif (10) selon l'une quelconque des revendications susmentionnées, comprenant en outre un moyen de transport de balayage afin de transporter relativement ledit produit testé (5) ou ladite source de lumière (1), une unité à spectromètre, une unité de collimation (4) et une caméra (3) dans une direction de balayage (9).

5. Dispositif selon l'une quelconque des revendications susmentionnées, dans lequel la caméra (3) consiste en une caméra à balayage linéaire comprenant de préférence une unité d'ouverture de caméra (24) et/ou une unité de lentilles parallaxes afin de réduire les effets de parallaxe, notamment une unité de lentilles cylindriques ou une unité de lentilles rondes, afin de recevoir un faisceau de lumière monochrome (32) réfléchi depuis ledit faisceau de lumière polychrome (31) par ledit produit testé (5), et/ou ladite caméra (3) consiste en une caméra numérique ayant une résolution de nuances d'au moins 8 bits, de préférence une résolution de nuances réglable de 10, 12 bits ou plus, et/ou ladite caméra (3) comprend deux rangées de balayage linéaire ou plus, chaque rangée comprenant un filtre couleur afin d'augmenter la sensibilité aux nuances, et/ou ladite caméra (3) comprend au moins une rangée de balayage de gris ou de noir et blanc afin d'augmenter la qualité de balayage, ou ladite caméra (3) consiste en une caméra de balayage de zone, une rangée unique ou des rangées multiples de balayage de ladite zone de balayage pouvant être extraites en vue d'un traitement des informations de hauteurs de nuances.

6. Dispositif selon l'une quelconque des revendications susmentionnées, comprenant au moins deux caméras (3) ou plus disposées dans une direction de l'axe y perpendiculaire à ladite direction de balayage x (9) pour un balayage parallèle, augmentant ainsi la largeur de balayage dudit produit (5), et/ou lesdites caméras (3) étant disposées de manière stéréométrique en vue d'un balayage 3D dudit produit (5) afin de réduire les effets d'ombre et d'illumination.

7. Dispositif selon l'une quelconque des revendications susmentionnées, comprenant en outre une unité de commande (21) connectée électriquement à au moins ladite caméra (3), laquelle unité de commande (21) comprenant des moyens de commande (22) et des moyens de cartographie de hauteurs de nuances (23) conçus pour commander au moins ladite caméra (3) et pour cartographier des valeurs de nuances d'une image prise par ladite caméra (3) en informations de hauteur de surface dudit produit (5).

8. Dispositif selon la revendication 7, comprenant en outre des moyens de réglage pouvant être commandés par lesdits moyens de commande (22) de ladite unité de commande (21) afin de régler la largeur du spectre couleur d (6) dudit faisceau polychrome (31), notamment afin de régler une largeur d'armature w (17) de ladite unité de collimation (4), et/ou afin de régler une hauteur de division du faisceau b, une distance a entre la ligne optique de la source (1) et la caméra (3) ou ledit angle de prisme α de ladite unité à spectromètre afin de régler la sensibilité de mesure de la hauteur.

9. Procédé de mesure optique de surface d'un produit testé (5), notamment un produit de type carte de circuit imprimé, afin d'inspecter la pâte de brasage par refusion en utilisant un dispositif selon l'une quelconque des revendications précédentes,
dans lequel un faisceau de lumière blanche est émis par ladite source de lumière blanche (1) et est redressé et collimaté par ladite unité de collimation (4) en un faisceau étroit parallèle (30) passant à travers ladite unité à spectromètre (2, 51) qui le désintègre en un spectre de couleurs (55) dont la réflexion sur ledit produit (5) ou des composants de celui-ci est enregistrée par ladite caméra (3) tout en déplaçant ledit produit (5) dans une direction de balayage (9) par rapport à ladite caméra (3), ceci de manière qu'une image composée par ladite caméra (3) à partir d'images individuelles représente toutes les parties de la surface dudit produit (5) et que les dimensions de l'image dans la direction des axes x et y correspondent aux dimensions réelles dudit produit (5), et qu'en même temps les valeurs de nuances de l'image, c'est-à-dire les valeurs de la partie couleur (R, V, B) des pixels individuels, soient attribuées à des valeurs de hauteur de surface dudit produit (5).

10. Procédé selon la revendication 9, dans lequel une cartographie de hauteurs de nuances des valeurs de nuances du spectre de couleurs (55) en des valeurs de hauteur de surface z est étalonnée par au moins un enregistrement graduel d'une déclinaison de surface d' un corps d'étalonnage (19) selon un angle d'étalonnage β (20) connu à l'avance avec une grande précision, et en mémorisant une carte de hauteurs de nuances dans un moyen de cartographie de hauteurs de nuances (23).

11. Procédé selon l'une quelconque des revendications précédentes, dans lequel la position géométrique de ladite caméra (3) et de ladite source de lumière (1) est statique pendant toute la durée du balayage et/ou une cartographie de hauteurs de nuances en temps réel est effectuée pendant le balayage en utilisant ladite carte de hauteurs de nuances.

12. Procédé selon l'une quelconque des revendications précédentes, dans lequel ladite caméra (3) enregistre graduellement et ligne par ligne les valeurs de nuances d'une surface dudit produit (5) pendant que l'on déplace relativement ladite caméra (3) contre ledit produit (5) dans une direction de balayage (9).

13. Procédé selon l'une quelconque des revendications précédentes, dans lequel ladite caméra (3) et ladite lumière blanche (1) sont réglées de sorte que le début (7) dudit spectre de couleurs (55) soit cartographié à une hauteur zéro et/ou que les valeurs de nuances enregistrées par ladite caméra (3) soient converties à l'aide d'une fonction de calibration, de préférence par une carte de hauteurs de nuances sur une hauteur de surface réelle du produit (5) ou de ses composants.

14. Procédé selon l'une quelconque des revendications précédentes, dans lequel un modèle 3D du produit (5) est créé en fonction des valeurs de x et y mesurées d'une image de ladite caméra (3) et d'une valeur de hauteur z en fonction des valeurs de nuances de ladite image sur les axes x et y.

15. Procédé selon l'une quelconque des revendications précédentes, dans lequel les dimensions d'un produit (5), notamment la position et la hauteur de la pâte de brasage par refusion sur un produit de type carte de circuit imprimé ou cellule solaire et/ou la rugosité de surface dudit produit (5), sont mesurées.
